# EUROPÄISCHE PATENTSCHRIFT

(11) **EP 1 137 970 B1**
(45) Veröffentlichungstag und Bekanntmachung des Hinweises auf die Patenterteilung: **21.06.2006**
(21) Anmeldenummer: 99968776.7
(22) Anmeldetag: 04.11.1999
(51) Int. Cl.: G03F 9/00, H05K 3/00

(54) **VERFAHREN UND VORRICHTUNG ZUM AUSRICHTEN ZWEIER FOTOMASKEN ZUEINANDER UND EINES UNBELICHTETEN LEITERPLATTEN-ROHLINGS UND ZUM ANSCHLIESSENDEN SIMULTANEN BELICHTEN BEI DER HERSTELLUNG VON DOPPELSEITIGEN LEITERPLATTEN**
METHOD AND DEVICE FOR ALIGNING TWO PHOTO MASKS WITH EACH OTHER AND AN UNEXPOSED PRINTED CIRCUIT BOARD BLANK, AND FOR SUBSEQUENT SIMULTANEOUS EXPOSURE IN THE PRODUCTION OF DOUBLE-SIDED PRINTED CIRCUIT BOARDS
PROCEDE ET DISPOSITIF D'ALIGNEMENT DE DEUX PHOTOMASQUES ET D'UNE EBAUCHE DE CARTE IMPRIMEE NON EXPOSEE ET D'EXPOSITION SIMULTANEE ULTERIEURE, LORS DE LA FABRICATION DE CARTES IMPRIMEES DOUBLE FACE

(30) Priorität: 09.11.1998 DE 19851575
(43) Veröffentlichungstag der Anmeldung: 04.10.2001
(73) Patentinhaber: MANIA Technologie AG, 61276 Weilrod (DE)
(72) Erfinder: GEBUREK, Frank, D-31162 Bad Salzdetfurth (DE)
(74) Vertreter: Ruschke, Hans Edvard
(86) Internationale Anmeldenummer: PCT/EP1999/008451
(87) Internationale Veröffentlichungsnummer: WO 2000/028385

(56) Entgegenhaltungen:
- EP-A- 0 618 505
- EP-A- 0 626 623
- EP-A- 0 807 856

## Beschreibung

Die vorliegenden Erfindung betrifft ein Verfahren und eine Vorrichtung zum Ausrichten zweier Fotomasken und gegebenenfalls eines unbelichteten Leiterplatten - Rohlings zueinander und zum anschließenden simultanen Belichten zum Zwecke der Herstellung von doppelseitigen Leiterplatten, wobei am Rand der Fotomasken und der Leiterplatten - Rohlinge optische Positionierungshilfen angeordnet sind. Zur Ausrichtung der Fotomasken und Leiterplatten zueinander sind keine zusätzlichen Positionierungsbohrungen und keine unabhängig einstellbaren Positionierungsstifte wie im Stand der Technik notwendig.

Die EP 184 820 A2 der Anmelderin zeigt eine Anordnung zur Ausrichtung von unbelichteten Leiterplatten - Rohlingen und Fotomasken zueinander bei der Herstellung von ein- und mehrlagigen Leiterplatten, mit am Rand der Fotomasken bzw. der Leiterplatten angeordneten, einander zugeordneten Positionierungshilfen, die bei der Leiterplatte die Form von Positonierungsbohrungen haben, wobei am Leiterplattenrohling auf einer oder beiden Seiten eine Fotomaske aufliegt. Die Positonierungshilfen am Rand der Fotomasken weisen die Form von lichtundurchlässigen Markierungen auf, die Bestandteil des Musters der Masken sind. Eine Lichtquelle richtet im wesentlichen paralleles Licht auf den Verbund aus Leiterplatten - Rohling und Fotomasken sowie auf die Positionierungsbohrungen und die entsprechenden Markierungen. Eine elektronische Zeilenkamera ist im Strahlengang des hindurchtretenden oder reflektierenden Restlichtes angeordnet und mit einer Auswertschaltung zur Ermittlung der Lage des Schattens der Markierungen im Verhältnis zu den Positionierungslöchern versehen.

Auch wenn dieser Stand der Technik über die Meßmethode zur Ermittlung der Ausrichtung der Leiterplatte und der Fotomaske zueinander Auskunft gibt, wird nichts darüber gesagt, wie die Leiterplatte bzw. die Fotomasken im Rahmen eines automatisierten Leiterplatten - Belichtungsgerätes gehandhabt werden sollen, um diese Meßmethode in effektiver Weise anzuwenden.

In der EP 618 505 A1 ist ein Belichtungsgerät für doppelseitige, gedruckte Schaltungen oder Leiterplatten mit Hilfe von Fotomasken gezeigt, von welchem die vorliegende Erfindung ausgeht. Dabei ist eine erste Halterung für de erste Fotomaske mit Positionsmarkierung vorgesehen, wobei außerdem Einrichtungen zum Einlegen der Leiterplatte zwischen die erste und zweite Fotomaskenhalterung vorgesehen ist. Optische Geräte zur Erkennung von Positionierungshilfen zwischen der Leiterplatte und der zweiten Halterung sowie zwischen der ersten und der zweiten Halterung oder zwischen der Leiterplatte und der ersten Halterung mit Hilfe von Positionserkennungs-verfahren sind ebenfalls vorgesehen. Um die zu belichtende Leiterplatte in Abhängigkeit von irgendwelchen zwischen den Fotomasken und der Leiterplatte ermittelten Positionierungsfehlern einstellen zu können, sind von zusätzlichen Motoren betriebene Verschiebeeinrichtungen mit zwei Stiften vorgesehen, die in zwei Richtungen parallel und rechtwinklig zur Leiterplatte verschoben werden, wobei die Leiterplatte am Rand mit zwei Bohrungen versehen ist, die die vorgenannten Stifte aufnehmen. Dieses bekannte Belichtungsgerät für Leiterplatten mit doppelseitig aufgebrachten Schaltungen erfordert somit neben der motorbetriebenen Einstellmechanik für die Foto-maskenhalterungen auch noch eine zusätzliche, ebenfalls motorbetriebene Einstellmechanik für die Positionierungsstifte für die zu belichtenden Leiter-platten, die ihrerseits mit Bohrungen für die vorgenannten Stifte versehen sein muß.

Die EP 807 856 A1, die unter anderem der US-PS 5,995,205 entspricht, befaßt sich zwar auch mit der Fixierung der Leiterplatte in einem Leiterplattenbelichtungsgerät, tut dies aber ebenfalls nur auf rein mechanische Weise, nämlich in der ersten Ausführungsform durch ein Einklemmen der Leiterplatte zwischen zwei Stiften und in der zweiten Ausführungsform durch einen speziellen Positionierungsstift. Dieser ist aber unter anderem deswegen nachteilig, weil er wiederum eine Bohrung in der Leiterplatte erforderlich macht.

In der EP 626 623, die der US-PS 5,604,354 entspricht, geht es um die im Stand der Technik vielfach bekannte Ausrichtung zweier Fotomasken zueinander mit Hilfe von optischen Markierungen, etwa zur Herstellung eines Silikon-Wafers. Die vorliegend beanspruchte Erfindung macht zwar grundsätzlich von einem in etwa vergleichbaren Positioniervefahren der Fotomasken zueinander Gebrauch, dieses Ausrichtverfahren ist aber nicht der wesentliche Aspekt der vorliegenden Erfindung.

Hiernach ist es ein Ziel der vorliegenden Erfindung, ein Verfahren bzw. eine Vorrichtung anzugeben, mit deren Hilfe die Mechanik des Gerätes insofern vereinfacht wird, daß keine separaten Stifte bzw. keine zugehörigen Antriebe notwendig sind, um die Stellung der Leiterplatte per se einjustieren zu können. Zur Ausrichtung der Fotomasken und Leiterplatten zueinander sollen also keine zusätzlichen Positionierungs-bohrungen und keine unabhängig einstellbaren Positionierungsstifte wie im Stand der Technik notwendig sein.

Durch die Erfindung wird die doppelseitige Ausrichtung zweier Fotomasken zueinander und zu dem Leiterplatten - Rohling einschließlich der Fixierung dieser Teile untereinander in besonders einfacher Weise ermöglicht, so daß sich eine Optimierung der vorhandenen Prozeßtoleranzen wie Bohr- / Lochlagetoleranz, Dimensionsstabilität des Basismaterials, Dimensionsstabilität der Filme ergibt.

Diese Aufgabe wird durch ein Verfahren bzw. eine Vorrichtung mit den Merkmalen der beigefügten Ansprüche gelöst. Das Gerät ist modular aufgebaut, d. h. mit gleicher Mechanik (Ausrichteinheit) lassen sich Außenlagen-, Innenlagen- und Stopplack - Belichtungen durchführen.

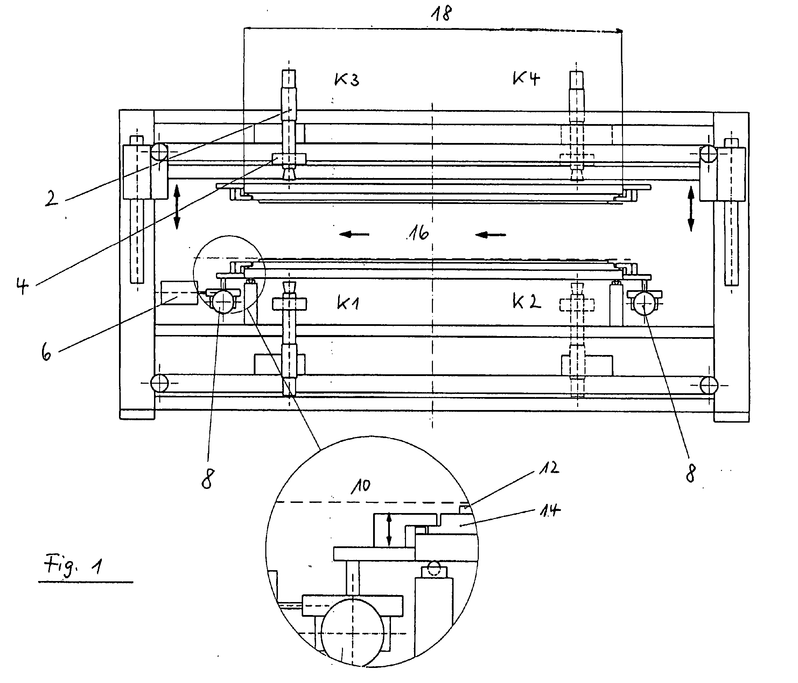

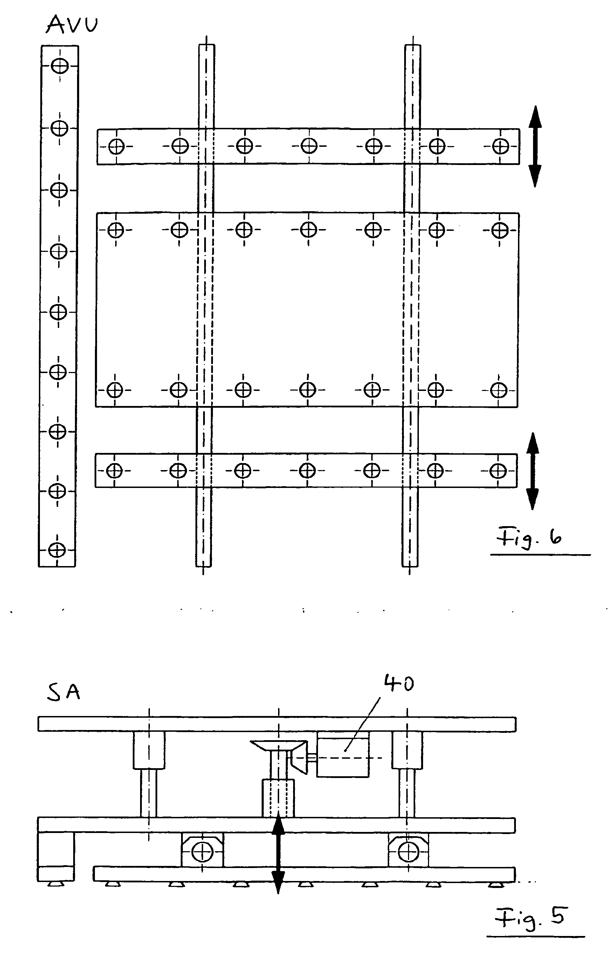

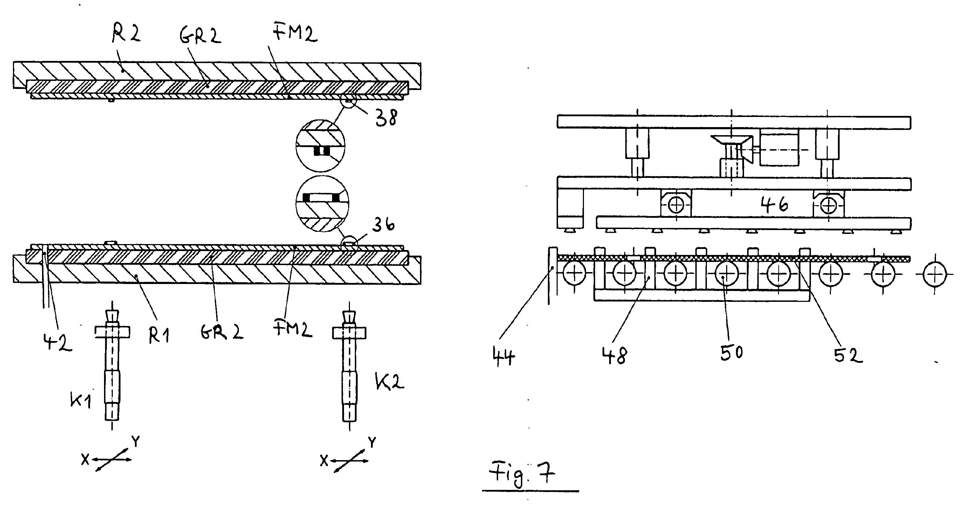

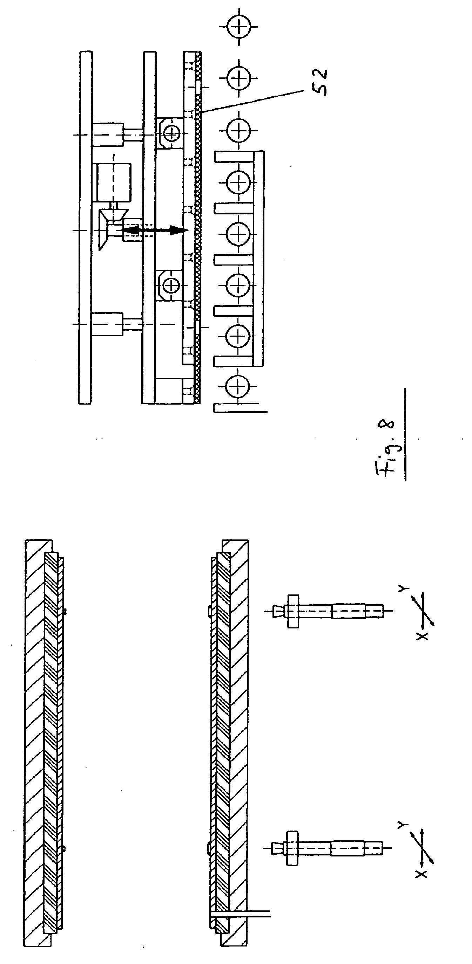

Zur Erläuterung der vorliegenden Erfindung wird diese unter Bezugnahme auf die beigefügten Zeichnungen beschrieben. Darin zeigen die Figuren 1 bis 6 in grundsätzlicher Darstellung einige wesentliche Teile eines erfindungsgemäßen Belichtungsgerätes für doppelseitige Leiterplatten (abgekürzt auch LP oder PCB genannt). Die Figuren 7 bis 12 zeigen einzelne Verfahrensschritte des Arbeitsablaufes dieses Belichtungsgerätes - wiederum in sehr prinzipieller Darstellungsweise, die sich nur auf die interessierenden Details beschränkt, also ohne jede unwesentliche Einzelheit wiederzugeben. Das Herzstück des Belichtungsgerätes ist die in Figur 1 dargestellte zentrale Belichtungseinheit, wobei rechts davon die horizontal und vertikal verschiebliche Saugerplatteneinheit gemäß Figur 5 (Seitenansicht) bzw. Figur 6 (Ansicht von unten) angeordnet wäre. Diese Saugerplatteneinheit bildet zusammen mit einem als Rollenband ausgebildeten Längsförderer die Einlaufsektion des Belichtungsgerätes, die im rechten Teil der Figur 7 schematisch dargestellt ist. Eine grundsätzlich gleichartig aufgebaute, horizontal und vertikal verschiebliche Saugerplatteneinheit wäre links von der Figur 1 als Auslaufsektion vorgesehen, und zwar zum Abtransportieren der fertig belichteten Leiterplatten in der Verlängerung der "Durchlaufrichtung" in Figur 1.
- Fig. 1: zeigt in prinzipieller, stark vereinfachter Darstellung die zentralen mechanischen Teile der Belichtungssektion - allerdings ohne die darüber bzw. darunter anzuordnenden Lichtquellen, vorzugsweise UV-Lichtquellen.

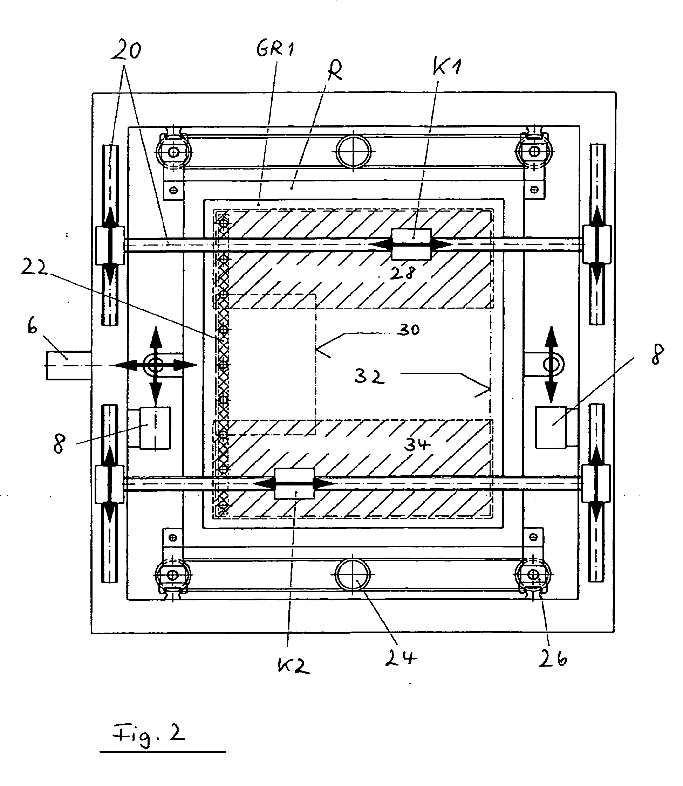

- Fig. 2: zeigt ebenfalls in prinzipieller stark vereinfachter Darstellung die Belichtungsektion der Figur 1 in einer Ansicht von oben.

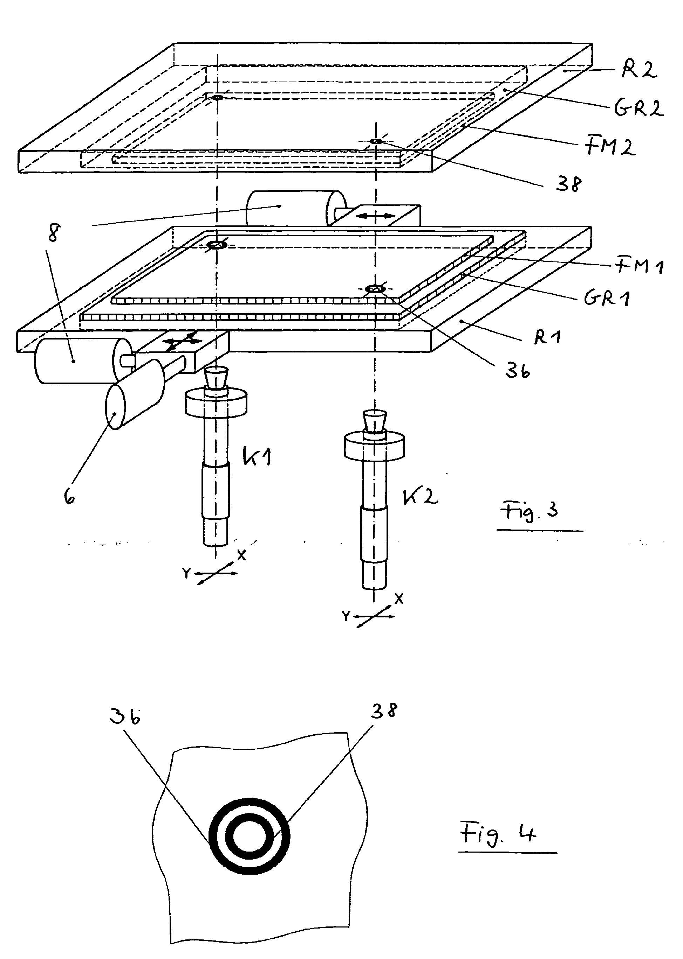

- Fig. 3: zeigt die wesentlichen, beweglichen Teile der Belichtungssektion der Figur 1 in einer perspektivischen Schrägansicht.
- Fig. 4: zeigt das Sichtfeld einer der Kameras K1 oder K2 bei ordnungsgemäß zueinander ausgerichteten Fotomasken FM1 bzw. FM2.
- Fig. 5: zeigt die horizontal nach links bzw. rechts verschiebliche Saugerplatteneinheit, deren unterer Teil zusätzlich in Richtung des Doppelpfeiles, also (beispielsweise vertikal) verstellbar ist.
- Fig. 6: zeigt eine Ansicht der Saugerplatte (auch Vakuumplatte genannt) der Figur 5 von unten.
- Fig. 7: zeigt einen ersten Schritt des erfindungsgemäßen Verfahrens, und zwar im linken Teil die auf den Rahmen bzw. Glasrahmen der Belichtungssektion (Figur 1) aufgelegten Fotomasken, sowie in ihrem rechten Teil die Einlaufsektion des Belichtungsgerätes mit dort bis zum Anschlag angeförderter Leiterplatte die von an den Seitenrändern angreifenden, in y-Richtung verfahrbaren Fingern in der Förderrichtung vorzentriert wird; darüber befindet sich die Saugerplätteneinheit der Fig. 5 in Bereitschaft zum Aufnehmen/Anheben der Leiterplatte.

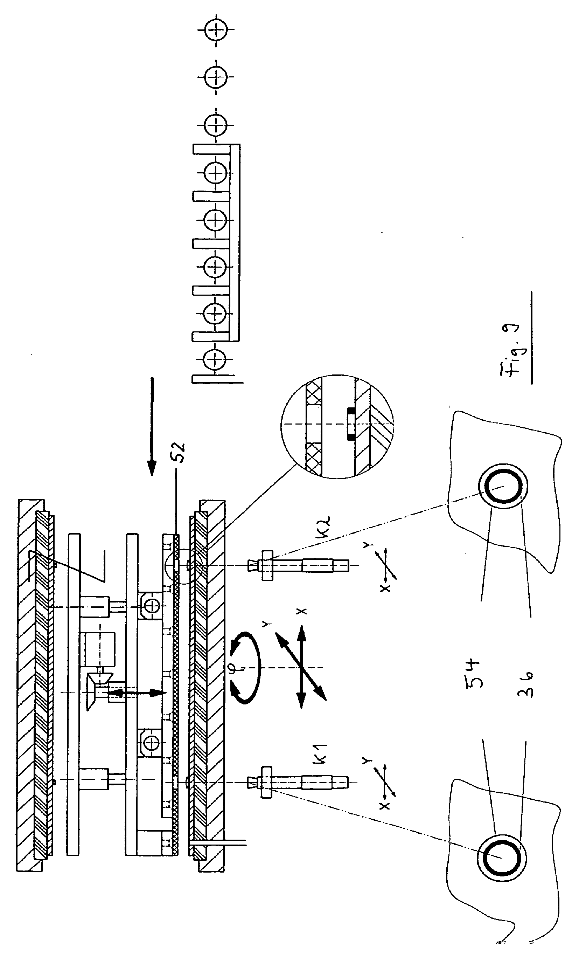

- Fig. 8: zeigt das Aufnehmen der Leiterplatte nach des Vorzentrierung, d.h. einen nächsten Schritt des Verfahrens, bei dem die Leiterplatte von der Saugerplatteneinheit von dem Rollenband der Fördermechanik abgehoben ist, und zwar als Vorbereitung zum Einfahren der Saugerplatteneinheit in Horizontalrichtung zwischen die linker Hand der Figur 8 mit (vertikalem) Abstand zueinander angeordneten Fotomasken.
- Fig. 9: zeigt den Transport der Leiterplatte in die Belichtungsstation, also das Ausrichten der Fotomaske 1 zur Leiterplattenseite 1 im nächsten Arbeitstakt der Vorrichtung, in dem die Saugerplatteneinheit der Fig. 5 nach links zwischen die beiden Fotomaskenhalterungen eingefahren ist. Dabei dienen die Kameras K1 und K2 zur exakten relativen Positionierung der Fotomaske 1 zur eingefahrenen Leiterplatte. Dies geschieht durch die von den Auswertschaltungen der beiden Kameras gesteuerten zwei Y-Achsenantriebe und den einen X-Achsenantrieb gemäß Figur 3, was im Ergebnis einer Einstellung der (unteren) Anordnung aus Rahmen, Glasrahmen und Fotomaske FM1 im Verhältnis zur unbeweglich gehalterten Leiterplatte nach X bzw. Y und Drehwinkel ϕ gleichkommt.

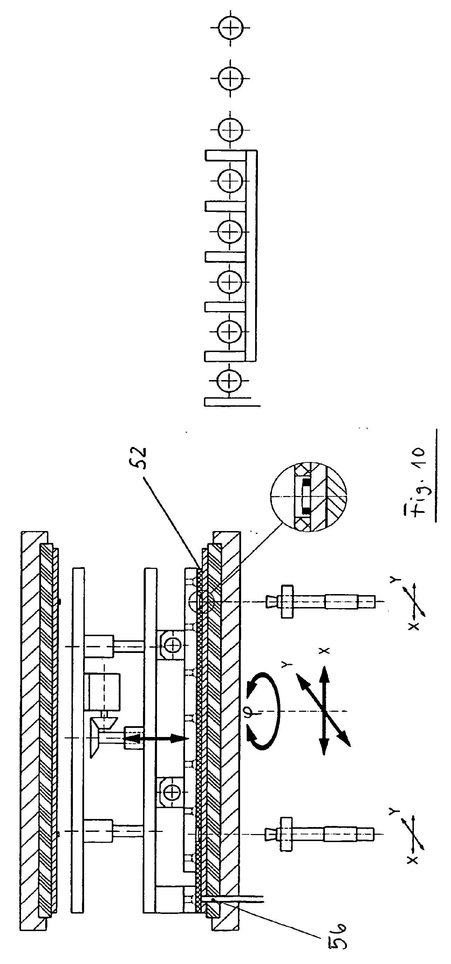

- Fig. 10: zeigt das Ablegen der Leiterplatte nach dem Ausrichten und die Fixierung der Leiterplatte mittels einer Vakuumleiste in einem weiteren Arbeitstakt des Belichtungsgerätes, nämlich das Ablegen der Leiterplatte durch die Saugerplatteneinheit auf die relativ dazu korrekt eingestellte bzw. positionierte (untere) Anordnung aus Rahmen, Glasrahmen und Fotomaske 1. Am Rand des unteren Glasrahmens der Figur 10 ist eine von außen mit Vakuum beaufschlagbare rechteckig umlaufende Vakuumnut vorgesehen, in der sich ein Vakuum aufbaut und die Fotomaske am Glasrahmen fixiert. Zugleich ist zusätzlich, beispielsweise am linken Rand, das Glas und die Fotomaske in diesem Bereich mit einer geraden Reihe von mit Vakuum beaufschlagten Bohrungen versehen, so daß sich das Vakuum auch auf die darauf gelegte Leiterplatte übertragen kann und diese ebenfalls festlegt bzw. fixiert (Leiterplatten fixierung mittels Vakuumleiste).

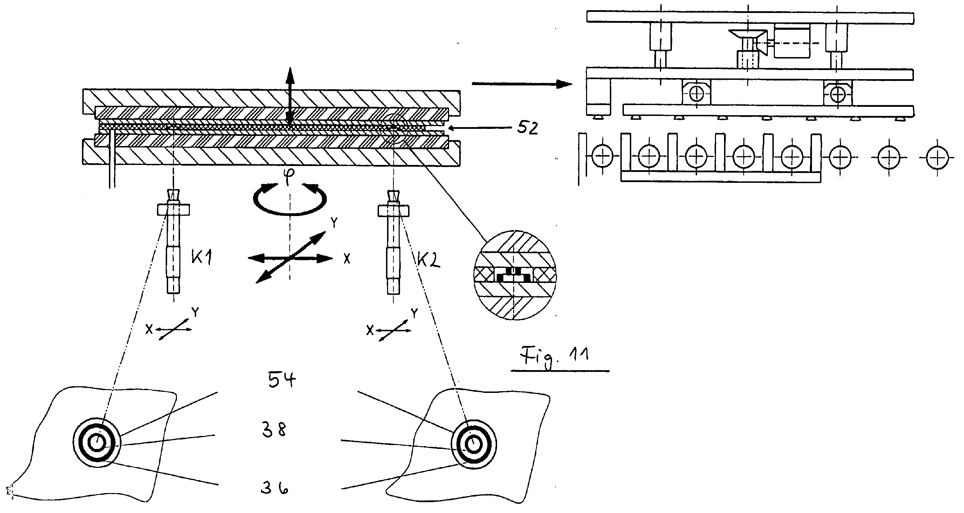

- Fig. 11: zeigt das Zusammenfahren von Glasrahmen 1 und 2, Kassettenvakuum, und Ausrichten des Unterrahmens mit der Leiterplatte zum Oberrahmen im nächsten Arbeitsschritt der Vorrichtung, bei dem die Saugerplatteneinheit der Fig. 5 wieder nach rechts in ihre Ausgangslage entsprechend den Figuren 7 und 8 zurückgefahren und der (obere) Glasrahmen GR2 mit der Fotomaske FM2 mittels der vierfach vorgesehenen "Hubspindeln mit Führungen" gemäß Figur 2 in eine Position dicht oberhalb der unteren Anordnung aus Glasrahmen GR1 und Fotomaske FM 1 sowie draufgelegter Leiterplatte verfahren ist, wonach die untere Anordnung nochmals im Verhältnis zu der sich darüber befindlichen Fotomaske ausgerichtet wird, und zwar unter Ausnutzung der fotooptischen Ausrichtung mit Hilfe der Kameras K1 und K2. Im unteren Teil der Figur 11 ist das Blickfeld der beiden Kameras im Zustand der ordnungsgemäßen Ausrichtung dieser Einzelteile zueinander dargestellt.

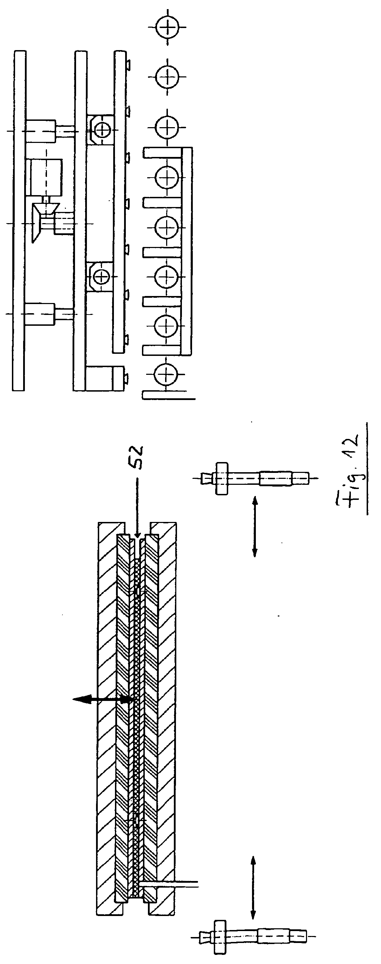

- Fig. 12: zeigt den letzten Schritt des Ausrichtverfahrens der Fotomasken FM1 und FM2 im Verhältnis zu der Leiterplatte: Der Glasrahmen GR2 mit der Fotomaske FM2 wird vollends gegen die Leiterplatte gefahren und die beiden Glasrahmen GR1 und GR2 werden dadurch aneinander fixiert, daß ein Kassettenvakuum aufgebracht wird, nämlich indem eine in den Zeichnungen nicht näher dargestellte umlaufende Randdichtung die Rahmen gegen die umgebende Atmosphäre abdichtet und der Innenraum mit dem sogenannten "Kassettenvakuum" beaufschlagt wird. In dieser Phase können die Kameras K1 und K2 nochmals eine optionale Endkontrolle der Ausrichtung der Einzelteile zueinander durchführen und, falls diese ein zufriedenstellendes Ergebnis bringt, wird die UV-Belichtung der Leiterplatte dadurch vorbereitet, daß die Kameras, wie in Figur 12 angedeutet, seitlich aus dem Belichtungsbereich herausgefahren werden. Die Verfahrmöglichkeit der Kameras 1 und 2 innerhalb des Belichtungsbereiches der Leiterplatten (PCB min bzw. PCB max) ist auch in Figur 2 im Detail angedeutet: Der von den Kameras erreichbare Bereich der größten bzw. kleinsten verarbeitbaren Leiterplatten ist dort schraffiert angedeutet und als Verfahrbereich der Kamera erläutert.

### Allgemeine Beschreibung des Belichtungsgerätes

Das Belichtungsgerät ist für Außenlagen, Innenlagen und Stopplack geeignet. "Außenlagen" sind die äußeren Leiterplatten bei Multilayer-Leiterplatten und entsprechen üblichen, beidseitig mit einer gedruckten Schaltung versehenen Leiterplatten; "Innenlagen" sind solche im Inneren von Multilayer-Leiterplatten und "Stopplack" bedeutet das fotooptische Aufbringen von Stopplack auf eine fertig hergestellte Leiterplatte z.B. zur Vorbereitung der Schwall-Lötung, also dem Anlöten elektronischer Bauteile an der Leiterplatte im Rahmen der weiteren Verarbeitung derselben.

Das Belichtungsgerät umfaßt eine Belichtungssektion (Figur 1) sowie links und rechts davon eine in Figur 1 nicht näher dargestellte Ein- bzw. Auslaufsektion, die beide jeweils lichtgeschützt sind, um das Austreten von gesundheitsschädlichem UV-Licht aus der Belichtungssektion zu verhindern. Die Belichtungssektion ist für verschiedene UV-Lichtquellen vorgesehen, auf die hier nicht weiter eingegangen zu werden braucht.

Das Herzstück der Belichtungssektion ist die Ausrichteinheit der Figur 1 mit einem Grundrahmen aus Aluminium zur Befestigung im nicht näher dargestellten Maschinenkörper. Am Grundrahmen sind vier hochpräzise Hubspindel-Führungen (Figur 2) mit Kugelrollspindeln für den oberen Glasrahmen GR2 befestigt. Der Antrieb für das Zueinanderfahren erfolgt über zwei synchronisierte Servomotoren, die gekoppelt über Zahnriemen auf je zwei Kugelrollspindeln arbeiten. Auf dem Grundrahmen als Ausrichteinheit ist der Glasrahmen GR1 gelagert. Er liegt zur leichten Manipulation mit geschliffenen Platten auf vier Kugeln. Die Manipulation erfolgt über drei Servomotoren, einer für die X-Richtung und zwei seitlich gegeneinander versetzte für die Y-Richtung und die daraus resultierenden Drehbewegung ϕ. Die Ansteuerung der Servomotoren erfolgt über die von den Kameras K1 bis K4 und deren Auswertschaltung ermittelten Zielkoordinaten. Eine zusätzliche Überprüfung der tatsächlichen Verfahrwege der Mechanik geschieht durch drei hochpräzise Glasmeßstäbe, die jedoch in den Zeichnungen nicht näher dargestellt sind.

Die sogenannten Glasrahmen GR1 und GR2 bestehen letztlich aus Alurahmen, in die thermisch gehärtete Glasscheiben mit Vakuumnuten für das Festhalten der dort aufgelegten Fotomasken eingeklebt sind. Das Gebilde aus Glasrahmen GR1 und GR2 wird im zusammengefahrenen Zustand im folgenden "Kassette" genannt. Die Kassette läßt sich durch spezielle Verriegelungseinrichtungen leicht aus der Ausrichteinheit entfernen, so daß neue Kassetten eingesetzt werden können. Die Einrichtung ist so aufgebaut, daß an Stelle der Fotomasken auch Glasmaster-Fotomasken eingesetzt werden können. Bei Glasmastem ist das abzubildende Leiterplatten-Layout direkt in die Glasscheibe geätzt, hierbei benötigt man keine Vakuumnuten im Glas, die die Fotomaske (auf Polyesterbasis, ca. 175 µm dick) festhalten müßten.

Wie aus dem schraffierten Bereich der Figur 2 ersichtlich ist, können die Kameras auf einen großen X/Y-Bereich von Leiterplatte und Fotomasken eingestellt werden, und zwar je nach den mit dem Gerät zu belichtenden Leiterplatten bzw. der Lage der optischen Positionierungshilfen an diesen. Die Kameras werden über Kompaktlineareinheiten mit Servomotoren verstellt und geführt. Das Anfahren der Positionierungshilfen durch die Kameras geschieht über manuelles Einstellen oder die Eingabe der X/Y-Zielkoordinaten. Bei einem späteren Aufruf eines gleichen Produktionsauftrages können diese Koordinaten automatisch angefahren werden. Die CCD-Kameras sind mit telezentrischen Objektiven und einer regelbaren LED-Ringbeleuchtung ausgestattet.

### Einlaufsektion

Die Einlaufsektion rechts von der Belichtungssektion der Figur 1 besteht aus einem Längsförderer in Gestalt eines Rollenbandes mit geschliffenen und polierten Edelstahlrollen, die das statische Aufladen verhindern. Die Einlaufsektion ist in prinzipieller Darstellung aus dem rechten Teil der Fig. 7 ersichtlich. Die Edelstahlrollen sind in einem Abstand von 80 mm zueinander angeordnet und die Zwischenräume sind abgedeckt, um dünne Materialien handhaben zu können und zur besseren Reinigung. Am Rollenband sind in Durchlaufrichtung am Ende ein in Längsrichtung mechanisch verstellbarer "Anschlag" sowie eine seitliche Zentriereinrichtung in Form von an den Längsrändern angreifenden schwenkbaren Fingern zur "Vorzentrierung" vorgesehen. Zum Transport der Leiterplatten in die Belichtungssektion wird ein Wagen mit Saugerplatte (bzw. "Vakuumplatte") eingesetzt, die sogenannte Saugerplatteneinheit, die in Figuren 5 und 6 gezeigt ist. Wie aus der Ansicht der Figur 6 hervorgeht, können die Sauger auf die jeweilige Leiterplattenbreite mit Hilfe von Servomotoren eingestellt bzw. verfahren werden. Die Sauger sind so angeordnet, daß die Leiterplatten absolut plan angesaugt werden. Der Hub an dem Saugerwagen bzw. an der Saugerplatteneinheit (siehe Doppelpfeil in Figur 5) wird ebenfalls über einen Servomotor präzise eingestellt.

### Auslaufsektion

Die in den Zeichnungen nicht näher dargestellte Auslaufsektion ist links von der Belichtungssektion der Figur 1 in Durchlaufrichtung hinter derselben angeordnet und besteht, wie die Einlaufsektion, aus einem Längsförderer in Gestalt eines Rollenbandes mit geschliffenen und polierten Edelstahlrollen, die das statische Aufladen verhindern. Die Edelstahlrollen sind in einem Abstand von 80 mm angeordnet. Die Zwischenräume sind, um dünne Materialien zu handeln und zur besseren Reinigung, abgedeckt. Zum Transport der Leiterplatten aus der Belichtungssektion in die Auslaufsektion wird wiederum eine Saugerplatteneinheit wie die der Figur 5 eingesetzt, also ein Wagen mit einer Sauger- oder Vakuumplatte. Auch hierbei werden die Sauger auf die jeweilige Leiterplattenbreite über Servomotoren eingestellt. Auf die weitere Beschreibung der Saugerplatteneinheit im Zusammenhang mit der Einlaufsektion wird verwiesen.

### Belichtungssektion

Aus der Figur 1 der Zeichnungen ergibt sich, daß bei der hier beschriebenen Ausführungsform eines Belichtungsgeräts die Leiterplatten in eine waagerecht angeordnete Belichtungssektion eingeführt werden. Es ist aber ohne weiteres denkbar, diesen Belichtungsraum zusammen mit der entsprechenden Mechanik so anzuordnen, daß er vertikal verläuft, was zum Beispiel unter besonderen Anforderungen an die Fehlerfreiheit der Belichtung von Vorteil sein kann, um die mögliche Ablagerung von Staub auf den Folien oder Glasrahmen zu vermeiden. Hiernach ist klar, daß wenn im vorliegenden Zusammenhang von oben oder unten die Rede ist, dies genau so gut mit links und rechts bezeichnet werden könnte.

Um die Fotomasken der sogenannten "Kassette" (Glasrahmen GR1 und Glasrahmen GR2) einzulegen, werden die entsprechenden Fotomasken FM1 und FM2 auf den Glasrahmen GR1 bzw. GR2 aufgelegt und dabei über geeignete Freistanzungen auf dem Glasrahmen vorpositioniert. Im Glasrahmen ist eine Vakuumnut vorgesehen, über die die Fotomaske auf der Glasscheibe fixiert wird. Nach diesem Vorgang hängt die Fotomaske FM1 am Glasrahmen GR1 und die Fotomaske FM2 am Glasrahmen GR2. Es ist auch möglich, an Stelle von "Fotomaske und Glasscheibe sogenannte" Glasmaster" zu verwenden, das heißt ein Glas mit dem dort eingeätzten Leiterplatten-Layout. Diese Glasmaster haben zugleich die benötigten optischen Positionierungshilfen am Rand und werden dann als "Kassette", bestehend aus Glasrahmen GR1 und Glasrahmen GR2 der Ausrichteinheit der Figur 1 zugeführt und automatisch verriegelt.

Beim Start eines Produktionsloses muß vom Bediener die Position der Positionierungshilfen für die Kameras eingeteacht oder die X/Y-Koordinaten eingegeben werden. Ebenso werden die spezifischen Daten der Leiterplatte, wie zum Beispiel Breite und Länge und Dicke der Leiterplatten, eingegeben.

### Ablaufbeschreibung bei "Außenlagen"

Eine Multilayer-Leiterplatte besteht aus zwei äußeren Leiterplatten, den sogenannten Außenlagen, und mehreren inneren Leiterplatten, den sogenannten Innenlagen. Bei der Außenlagen-Belichtung besteht die Aufgabe darin, die Fotomaske FM1 zu der ihr zugewandten Seite der Leiterplatte exakt auszurichten, sowie die Fotomaske FM2 zur ihr zugewandten anderen Leiterplattenseite exakt auszurichten. Die Positionierungshilfen in den Fotomasken sind Kreisringe und in der Außenlage-Leiterplatte eine Durchgangsbohrung - siehe zum Beispiel die Darstellung im unteren Bereich der Figur 11 der Zeichnungen.

Im Automatikmodus des Belichtungsgerätes laufen dann die Außenlagen-Leiterplatten über das Rollenband des Längsförderers bis zum vorderen Anschlag und werden dann über die seitlichen Zentrierfinger der "Vorzentrierung" hinreichend genau vorpositioniert und von der Saugerplatte mittels Vakuum übernommen (rechte Hälfte der Figur 8). Die Saugerplatte transportiert dann die Leiterplatte in die Belichtungssektion (linker Teil der Figur 9), wobei der Antrieb über in den Zeichnungen nicht näher dargestellte Kugelumlaufspindeln erfolgt, die mit Hilfe von Servomotoren angetrieben werden. In der Belichtungssektion hat die Leiterplatte dann einen definierten (vertikalen) Abstand von ca. 2 mm zur (unteren) Fotomaske FM1. Über die von den Auswertschaltungen der Kameras K1 und K2 errechten Koordinaten wird die Fotomaske dann zusammen mit dem Glasrahmen auf die ihr zugewandte Seite der Leiterplatte ausgerichtet. Nach der Ausrichtung wird die Leiterplatte vollends auf der unteren Fotomaske abgelegt und über die "Leiterplattenfixierung mittels Vakuum" fixiert, das heißt in der damit gegebenen Position festgehalten. Danach fährt die Saugerplatteneinheit wieder zurück in die Übemahmeposition (rechte Hälfte der Figur 11) für die nächste Leiterplatte. Im Anschluß daran fährt der (obere) Glasrahmen GR2 bis auf einen Abstand von ca. 2 mm zu der ihr zugewandten Leiterplattenseite, worauf dann die Ausrichtung der Fotomaske FM2 zu der ihr zugewandten Leiterplattenseite erfolgt. Dies geschieht wiederum durch das Verfahren des Glasrahmens GR1 mit der darauf fixierten Fotomaske FM1 an der darauf fixierten Leiterplatte 1, und zwar über die von den Kameras ermittelten Zielkoordinaten. Nach der erfolgreichen Ausrichtung wird dann ein sogenanntes "Kassettenvakuum" gezogen, das heißt am äußeren Rand des oberen Glasrahmens GR1 ist eine umlaufende elastische Randdichtung vorgesehen, die das Innere der Kassette gegen die Außenluft absperrt, so daß beide Glasrahmen mit den jeweiligen Fotomasken gegen die Leiterplatte beaufschlagt werden und alle diese Teile somit gegeneinander fixiert werden. In diesem Zustand kann optional eine sogenannte Finish-Kontrolle unter Vakuum durchgeführt werden. Wenn hierbei die voreingestellten Toleranzen für die Positioniergenauigkeit der Fotomasken und der Leiterplatten zueinander eingehalten sind, wird die UV-Belichtung der Leiterplatte ausgelöst.

Nach dieser UV-Belichtung fährt dann der (obere) Glasrahmen GR2 wieder in seine (obere) Ausgangsposition, so daß die (zeichnerisch nicht dargestellte) Saugerplatteneinheit der Auslaufeinheit die Leiterplatte aus der Belichtungssektion abholen kann, was synchron mit dem Einlaufwagen der Einlaufsektion geschehen kann, die die nächste Leiterplatte in die Belichtungssektion einfährt.

### Ablaufbeschreibung bei "Innenlagen"

Bei der Belichtung von Innenlagen-Leiterplatten besteht die Aufgabe darin, die Fotomaske FM1 zur Fotomaske FM2 exakt auszurichten. Auch hierbei sind die Positionierungshilfen an den Fotomasken Kreisringe. Innenlagen-Leiterplatten benötigen im vorliegenden Zusammenhang keine Bohrung zur Aufnahme von verstellbaren Positionierungsstiften wie im Stand der Technik. Im übrigen kommt es bei diesen sogenannten Innenlagen weniger auf eine ganz genaue Ausrichtung der unbelichteten Leiterplatte im Verhältnis zu den beiden äußeren Fotomasken an, die untereinander allerdings sehr genau ausgerichtet sein müssen. Deshalb müssen die Fotomasken FM1 und FM2 durch die Kameras K1 und K2 sehr genau zueinander ausgerichtet werden, bevor eine Leiterplatte in die Belichtungssektion einläuft. Dies geschieht in der Weise, daß zunächst die Fotomasken FM1 und FM2 in die jeweiligen Glasrahmen GR1 und GR2 manuell eingelegt und mit Hilfe der Freistanzungen auf den Glasrahmen grob festgelegt werden. Im Anschluß daran wird der (obere) Glasrahmen mit der daran festliegenden Fotomaske (Vakuumnut) mit Hilfe der Hubspindeln für den Servoantrieb derselben (siehe Figur 2) bis dicht über den (unteren) Glasrahmen GR1 und die dort befindliche Fotomaske FM1 eingefahren (Abstand < = 2 mm), wonach eine Ausrichtung der Fotomasken FM1 und FM2 zueinander durch die Kameras K1 und K2 vorgenommen bzw. kontrolliert wird. Dies geschieht dadurch, daß wiederum der untere Glasrahmen derart durch die Servoantriebe in X- und Y-Richtung verstellt wird, daß die beiden Fotomasken exakt aufeinander ausgerichtet sind. Danach wird der (obere) Glasrahmen mit der Fotomaske in die Position der Figur 7 hochgefahren.

Im Automatikmodus des Belichtungsgerätes laufen dann nacheinander die zu belichtenden Innenlagen-Leiterplatten über das Rollenband der Förderanordnung bis zum vorderen "Anschlag", werden dort über die seitlichen Zentrierfinger der "Vorzentrierung" der Fig. 7 hinreichend genau vorpositioniert und von der Saugerplatte mittels Vakuum übernommen. Die Sauger- oder Vakuumplatte transportiert dann die Innenlage-Leiterplatte in die Belichtungssektion in der schon beschriebenen Weise. Der Wagen mit der Saugerplatte legt die Innenlage auf der Fotomaske FM1 ab, wobei die Leiterplatte durch die Einwirkung der Vakuumleiste fixiert wird. Danach fährt der Wagen mit der Saugerplatte wieder in die Übernahmeposition für die nächste Leiterplatte. Der Glasrahmen 2 fährt anschließend abwärts auf die Kontaktposition zur fixierten Innenlage-Leiterplatte, wonach das Kassettenvakuum in der schon beschriebenen Weise gezogen wird. Von den Kameras K1 und K2 wird eine sogenannte Finish-Kontrolle durchgeführt. Liegen die ermittelten Abweichungen innerhalb der vorgegebenen Toleranz, wird die UV-Belichtung ausgelöst. Ansonsten wird eine erneute Ausrichtung der Fotomasken zueinander durchgeführt. Ist eine Ausrichtung nicht möglich, wird die Innenlage-Leiterplatte unbelichtet heraustransportiert.

Nach der UV-Belichtung fährt der Glasrahmen GR2 wieder in seine obere Ausgangsposition, so daß der Auslaufwagen mit der Saugerplatte die Leiterplatte aus der Belichtungssektion abholen und in die Auslaufsektion transportieren kann. Synchron damit holt der Einlaufwagen die nächste Leiterplatte in die Belichtungssektion.

### Ablaufbeschreibung bei "Stopplack"

Bei der sogenannten Stopplack-Belichtung besteht die Aufgabe darin, die Fotomaske FM1 zur gegenüberliegenden Leiterplattenseite sowie die Fotomaske FM2 zur gegenüberliegenden Leiterplattenseite exakt auszurichten. Die Positionierungshilfen in den Fotomasken sind wiederum Kreisringe und auf der Leiterplatte geeignete (reflektierende) Kupfermarken.

Im Automatikmodus des Belichtungsgerätes laufen die Leiterplatten über das Rollenband bis zum vorderen "Anschlag", werden dort über die seitliche Zentrierung hinreichend genau vorpositioniert und von der Saugerplatte mittels Vakuum übernommen. Diese Saugerplatte transportiert dann die Leiterplatte in die Belichtungssektion. In der Belichtungssektion hat die Leiterplatte einen definierten Abstand (ca. 2 mm) zur Fotomaske FM1. Über die von den Kameras K1 und K2 und deren Auswertschaltungen errechneten Koordinaten wird die Fotomaske zur gegenüberliegenden Leiterplattenseite ausgerichtet. Nach der Ausrichtung wird die Leiterplatte auf die untere Fotomaske vollends abgelegt und über die Vakuumleiste fixiert, d. h. in Position gehalten. Danach fährt die Saugerplatte wieder in die Übemahmeposition für die nächste Leiterplatte zurück. Im Anschluß hieran verfährt der Glasrahmen GR2 bis auf einen Abstand von ca. 2 mm zur gegenüberliegenden Leiterplattenseite, hier erfolgt dann die Ausrichtung der Fotomaske FM2 zur gegenüberliegenden Leiterplattenseite, und zwar wiederum durch Verfahren des (unteren) Glasrahmens GR1, bestehend aus Glasrahmen mit Fotomaske und fixierter, korrekt ausgerichteter Leiterplatte. In diesem Fall geschieht dies mit den Kameras K3 und K4 bzw. über die von deren Auswertschaltung ermittelten Zielkoordinaten des von der Kupfermarke reflektierten Lichtes.

Nach erfolgreicher Ausrichtung wird das sogenannte "Kassetten-Vakuum" erzeugt, und, wenn gewünscht, über die Kameras K1, K2, K3 und K4 die sogenannte Finish-Kontrolle unter Vakuum durchgeführt. Sind hierbei die voreingestellten Toleranzen eingehalten, so wird die UV-Belichtung ausgelöst.

Nach der Belichtung fährt der Glasrahmen GR2 wieder in die (obere) Ausgangsposition, so daß der Auslaufwagen der Auslaufsenktion mit der Saugerplatte die Leiterplatte aus der Belichtungssektion abholen kann, wobei synchron der Einlaufwagen der Einlaufsektion mit der nächsten Leiterplatte in die Belichtungssektion einfährt.

### Bezugszeichenliste

- 2: Kamera mit telezentrischem Objektiv
- 4: Ringlicht LED
- 6: Servoantrieb X-Richtung
- 8: Servoantrieb Y-Richtung
- 10: Kassettenfixierung
- 12: Glas
- 14: Kassettenrahmen
- 16: Durchlaufrichtung
- 18: Breite - Kassettenzufuhr
- 20: Kamera - Verfahrachsen
- 22: Saugerleiste zur Fixierung der PCB
- 24: Servoantrieb für Hubspindel
- 26: Hubspindel mit Führung (vierfach)
- 28: Verfahrbereich Kamera 1 (= K1)
- 30: PCB min. (= Mindestgröße der zu prüfenden Leiterplatte PCB)
- 32: PCB max. (= Madximalgröße der zu prüfenden Leiterplatte PCB)
- 34: Verfahrbereich der Kamera 2 (= K2)
- 36: Positionierungshilfe Fotomaske 1 (= FM1)
- 38: Positionierungshilfe Fotomaske 2 (= FM2)
- 40: Servoantrieb für Z-Hub
- 42: Vakuumleiste
- 44: Anschlag
- 46: Vakuumplatte
- 48: Vorzentrierung
- 50: Transportband
- 52: Leiterplatte (LP)
- 54: Bohrung (Leiterplatte)
- 56: Leiterplattenfixierung mittels Vakuumleiste

- AVU: Ansicht von unten
- FM1: Fotomaske 1
- FM2: Fotomaske 2
- GR1: Glasrahmen 1
- GR2: Glasrahmen 2
- K1: Kamera 1
- K2: Kamera 2
- K3: Kamera 3
- K4: Kamera 4
- LP: Leiterplatte (52)
- R: Rahmen
- R1: Rahmen 1
- R2: Rahmen 2
- SA: Seitenansicht

## Patentansprüche

1. Verfahren zum Ausrichten eines unbelichteten Leiterplatten-Rohlinges und zweier Fotomasken zueinander ohne zusätzliche mechanische Hilfsmittel wie verstellbare Positionierungsstifte für die Leiterplatte, und zum anschließenden Belichten zum Zwecke der Herstellung von doppelseitigen Leiterplatten, vorzugsweise zur Verwendung als Außenlagen von Multilayer-Leiterplatten, wobei am Rand der Fotomasken und der Leiterplatte optische Positionierungshilfen angeordnet sind, mit folgenden Schritten:
A) Vorsehen einer ersten Anordnung aus einer ersten Fotomaske (FM1) auf einem in seiner Ebene nach den Koordinaten x, y und ϕ einstellbaren Glasrahmen (GR1);
B) Vorsehen einer zweiten Anordnung aus einer zweiten Fotomaske (FM2) auf einem in einer festen xy-Position angeordneten, aber in z-Richtung einstellbaren und zur ersten Anordnung parallelen zweiten Glasrahmen (GR2), der zunächst in z-Richtung einen Abstand von der ersten Anordnung (GR1 + FM1) hat;
C) Einfahren der zu belichtenden Leiterplatte (LP) auf eine feststehende xy-Position in dem Bereich zwischen der ersten Anordnung (GR1 + FM1) und der zweiten Anordnung (GR2 + FM2);
D) Ausrichten der ersten Anordnung (GR1 + FM1) nach den Koordinaten x, y und ϕ auf die Leiterplatte (LP) in der vorgenannten festen Position mittels Kameras (K1, K2 etc.) im Zusammenwirken mit den optischen Positionierungshilfen auf der Fotomaske (FM1) und der Leiterplatte (LP);
E) Absenken in der z-Koordinate und Fixieren der Leiterplatte (LP) auf der dementsprechend ausgerichteten ersten Anordnung (GR1 + FM1) zur Ausbildung einer dritten Anordnung aus erstem Glasrahmen und erster Fotomaske und der Leiterplatte (GR1 + FM1 + LP);
F) Ausrichten der dritten Anordnung (GR1 + FM1 + LP) nach den Koordinaten x, y und ϕ auf die zweite Anordnung (GR2 + FM2) mittels der Kameras (K1, K2 etc.) im Zusammenwirken mit den optischen Positionierungshilfen auf den Fotomasken (FM1 bzw. FM2) und auf der Leiterplatte (LP);
G) Absenken in der z-Koordinate und Ablegen der zweiten Anordnung (GR2 + FM2) auf die dementsprechend ausgerichtete dritte Anordnung (GR1 + FM1+ LP) und Fixieren derselben mittels Kassettenvakuum zur Ausbildung einer vierten Anordnung aus erstem Glasrahmen und erster Fotomaske und Leiterplatte und zweiter Fotomaske und zweitem Glasrahmen (GR1 + FM1+ LP + FM2 + GR2);
H) Belichten der vierten Anordnung (GR1 + FM1 + LP + FM2 + GR2) von beiden Seiten derselben zur Ausbildung der gleichzeitig beidseitig belichteten Leiterplatte (LP),
**dadurch gekennzeichnet, daß** im Schritt E) die Leiterplatte auf der ersten Anordnung mittels Vakuum fixiert wird, das sich über Bohrungen am Rand des ersten Glasrahmens und der ersten Fotomaske auf die darauf gelegte Leiterplatte überträgt.

2. Verfahren zum Ausrichten eines unbelichteten Leiterplatten-Rohlinges und zweier Fotomasken zueinander ohne zusätzliche mechanische Hilfsmittel wie verstellbare Positionierungsstifte für die Leiterplatte, und zum anschließenden Belichten zum Zwecke der Herstellung von doppelseitigen Leiterplatten, vorzugsweise zur Verwendung als Innenlagen von Multilayer-Leiterplatten, wobei am Rand der Fotomasken optische Positionierungshilfen angeordnet sind, mit folgenden Schritten:
a) Vorsehen einer ersten Anordnung aus einer ersten Fotomaske (FM1) auf einem in seiner Ebene nach den Koordinaten x, y und ϕ einstellbaren ersten Glasrahmen (GR1);
b) Vorsehen einer zweiten Anordnung aus einer Fotomaske (FM2) auf einem in einer festen xy-Position angeordneten, aber in z-Richtung einstellbaren und zur ersten Anordnung parallelen zweiten Glasrahmen (GR2), der in z-Richtung auf einen kleinen Abstand von der ersten Anordnung (GR1 + FM1) eingefahren wird;
c) Ausrichten der ersten Anordnung (GR1 + FM1) nach den Koordinaten x, y und ϕ auf die zweite Anordnung (GR2 + FM2) in der vorgenannten festen xy-Position mittels Kameras (K1, K2 etc.) im Zusammenwirken mit den optischen Positionierungshilfen auf der ersten Fotomaske (FM1) und der zweiten Fotomaske (FM2);
d) Auseinanderfahren der ersten Anordnung (GR1 + FM1) und der zweiten Anordnung (GR2 + FM2) auf einen ausreichenden Abstand zum Einfahren der zu belichtenden Leiterplatte (LP) auf eine feste xy-Position in dem Bereich zwischen der ersten Anordnung (GR1 + FM1) und der zweiten Anordnung (GR2 + FM2);
e) Absenken der Leiterplatte in der z-Koordinate auf die erste Anordnung und Fixieren der Leiterplatte (LP) auf der ersten Anordnung (GR1 + FM1) zur Ausbildung einer dritten Anordnung aus erstem Glasrahmen und erster Fotomaske und Leiterplatte (GR1 + FR1 + LP);
f) Absenken in der z-Koordinate der zweiten Anordnung (GR2 + FM2) auf die dementsprechend ausgerichtete dritte Anordnung (GR1 + FM1 + LP) und Fixieren derselben mittels Kassettenvakuum zur Ausbildung einer vierten Anordnung aus erstem Glasrahmen und erster Fotomaske und Leiterplatte und zweiter Fotomaske und zweitem Glasrahmen (GR1 + FR1 + LP + FM2 + GR2);
g) Belichten der vierten Anordnung (GR1 + FM1 + LP + FM2 + GR2) von beiden Seiten derselben zur Ausbildung der gleichzeitig beidseitig belichteten Leiterplatte (LP),
**dadurch gekennzeichnet, daß** im Schritt e) die Leiterplatte auf der ersten Anordnung mittels Vakuum fixiert wird, das sich über Bohrungen am Rand des ersten Glasrahmens und der ersten Fotomaske auf die darauf gelegte Leiterplatte überträgt.

3. Vorrichtung zur Durchführung des Verfahrens nach Anspruch 1, mit folgenden Merkmalen:
A) Eine erste Anordnung aus einer ersten Fotomaske (FM1) auf einem in seiner Ebene nach den Koordinaten x, y und ϕ einstellbaren ersten Glasrahmen (GR1);
B) Eine zweite Anordnung aus einer zweiten Fotomaske (FM2) auf einem in einer festen xy-Position angeordneten, aber in z-Richtung einstellbaren und zur ersten Anordnung parallelen zweiten Glasrahmen (GR2), der zunächst in z-Richtung einen Abstand von der ersten Anordnung (GR1 + FM1) hat;
C) Eine Einlaufsektion des Belichtungsgerätes zum Einfahren der zu belichtenden Leiterplatte (LP) auf eine feststehende xy-Position in dem Bereich zwischen der ersten Anordnung (GR1 + FM1) und der zweiten Anordnung (GR2 + FM2);
D) Kameras (K1, K2 etc.) zum Ausrichten der ersten Anordnung (GR1 + FM1) nach den Koordinaten x, y und ϕ auf die zwischen die erste und die zweite Anordnung eingefahrene Leiterplatte (LP) in der vorgenannten festen Position im Zusammenwirken mit den optischen Positionierungshilfen auf der Fotomaske (FM1) und der Leiterplatte (LP);
E) Ein Servoantrieb für z-Hub zum Absenken der Leiterplatte in der z-Koordinate und Mittel zum Fixieren der Leiterplatte (LP) auf der dementsprechend ausgerichteten ersten Anordnung (GR1 + FM1) zur Ausbildung einer dritten Anordnung aus erstem Glasrahmen und erster Fotomaske und der Leiterplatte (GR1 + FM1 + LP);
F) Kameras (K1, K2 etc.) zum Ausrichten der dritten Anordnung (GR1 + FM1 + LP) nach den Koordinaten x, y und ϕ auf die zweite Anordnung (GR2 + FM2) im Zusammenwirken mit den optischen Positionierungshilfen auf den Fotomasken (FM1 bzw. FM2) und auf der Leiterplatte (LP);
G) Hubspindeln zum Absenken in der z-Koordinate und Ablegen der zweiten Anordnung (GR2 + FM2) auf die dementsprechend ausgerichtete dritte Anordnung (GR1 + FM1 + LP) und Fixieren derselben mittels Kassettenvakuum zur Ausbildung einer vierten Anordnung aus erstem Glasrahmen und erster Fotomaske und Leiterplatte und zweiter Fotomaske und zweitem Glasrahmen (GR1 + FM1 + LP + FM2 + FR2);
H) Lichtquellen zum Belichten der vierten Anordnung (GR1 + FM1 + LP + FM2 + GR2) von beiden Seiten derselben zur Ausbildung der gleichzeitig beidseitig belichteten Leiterplatte (LP),
**dadurch gekennzeichnet, daß** im Merkmal E) die Mittel zum Fixieren der Leiterplatte auf der ersten Anordnung Vakuumbohrungen sind, die sich durch den ersten Glasrahmen und die erste Fotomaske erstrecken und die Leiterplatte aufgrund des anliegenden Vakuums fixieren.

4. Vorrichtung zum Durchführen des Verfahrens nach Anspruch 2, mit folgenden Merkmalen:
a) Eine erste Anordnung aus einer ersten Fotomaske (FM1) auf einem in seiner Ebene nach den Koordinaten x, y und ϕ einstellbaren ersten Glasrahmen (GR1);
b) Eine zweite Anordnung aus einer zweiten Fotomaske (FM2) auf einem in einer festen xy-Position angeordneten, aber in z-Richtung einstellbaren und zur ersten Anordnung parallelen zweiten Glasrahmen (GR2), der in z-Richtung auf einen kleinen Abstand von der ersten Anordnung (GR1 + FM1) eingefahren wird;
c) Kameras (K1, K2 etc.) zum Ausrichten der ersten Anordnung (GR1 + FM1) nach den Koordinaten x, y und ϕ auf die zweite Anordnung (GR2 + FM2) in der vorgenannten festen xy-Position im Zusammenwirken mit den optischen Positionienmgshilfen auf der ersten Fotomaske (FM1) und der zweiten Fotomaske (FM2);
d) Hubspindeln zum Auseinanderfahren der zweiten Anordnung (GR2 + FM2) von der ersten Anordnung (GR1 + FM1) auf einen ausreichenden Abstand zum Einfahren der zu belichtenden Leiterplatte (LP) auf eine feste xy-Position in dem Bereich zwischen der ersten Anordnung (GR1 + FM1) und der zweiten Anordnung (GR2 + FM2);
e) Servoantrieb für z-Hub zum Absenken der Leiterplatte in der z-Koordinate und Mittel zum Fixieren der Leiterplatte (LP) auf der ersten Anordnung (GR1 + FM1) zur Ausbildung einer dritten Anordnung aus erstem Glasrahmen und erster Fotomaske und der Leiterplatte (GR1 + FM1 + LP);
f) Hubspindeln zum Absenken in der z-Koordinate der zweiten Anordnung (GR2 + FM2) auf die dementsprechend ausgerichtete dritte Anordnung (GR1 + FM1 + LP) und Fixieren derselben mittels Kassettenvakuum zur Ausbildung einer vierten Anordnung aus erstem Glasrahmen und Fotomaske und Leiterplatte und zweiter Fotomaske und zweitem Glasrahmen (GR1 + FM1 + LP + FM2 + GR2);
g) Lichtquellen zum Belichten der vierten Anordnung (GR1 + FM1 + LP + FM2 + GR2) von beiden Seiten derselben zur Ausbildung der gleichzeitig beidseitig belichteten Leiterplatte (LP),
**dadurch gekennzeichnet, daß** im Merkmal e) die Mittel zum Fixieren der Leiterplatte auf der ersten Anordnung Vakuumbohrungen sind, die sich durch den ersten Glasrahmen und die erste Fotomaske erstrecken und die Leiterplatte aufgrund des anliegenden Vakuums fixieren.

## Claims

1. A process of aligning an unexposed PCB blank and two photomasks with each other without additional mechanical aids such as adjustable PCB positioning pins, and of subsequently exposing said blank for the production of two-sided PCBs, preferably for use as the outer layers of multi-layer PCBs, with optical positioning means provided along the edges of the photomasks and of the PCB, comprising the following steps:
A) Providing a first assembly consisting of a first photomask (FM1) placed on a glass frame (GR1) adjustable in its plane in the x, y and ϕ coordinates;
B) providing a second assembly consisting of a second photomask (FM2) placed on a second glass frame (GR2) disposed in a fixed xy position but adjustable in the z direction and located in parallel with said first assembly, said second glass frame initially spaced a distance in the z direction from said first assembly (GR1 + FM1);
C) moving the the PCB (LP) to be exposed into a fixed xy position in the area between the first assembly (GR1 + FM1) and the second assembly (GR2 + FM2);
D) aligning the first assembly (GR1 + FM1) in the x,y and ϕ coordinates with the PCB (LP) in the aforesaid fixed position thereof by means of cameras (K1, K2, etc.) in cooperation with said optical positioning aids on the photomask (FM1) and the PCB (LP);
E) lowering the PCB (LP) in the z coordinate onto and securing it to the correspondingly aligned first assembly (GR1 + FM1) for forming a third assembly (GR1 + FM1 + LP) comprising the first glass frame, the first photomask and the PCB;
F) aligning the third assembly (GR1 + FM1 + LP) in the x, y and ϕ coordinates with the second assembly (GR2 + FM2) by means of cameras (K1, K2, etc.) in cooperation with the optical positioning aids on the photomasks (FM1 and FM2, respectively) and on the PCB (LP);
G) lowering the second assembly (GR2 + FM2) onto and securing it to the correspondingly aligned third assembly (GR1 + FM1 + LP) and securing it by means of cassette vacuum for the formation of a fourth assembly (GR1 + FM1 + LP + FM2 + GR2) comprising the first glass frame, the first photomask, the PCB, the second photomask and the second glass frame; and
H) exposing the fourth assembly (GR1 + FM1 + LP + FM2 + GR2) on both sides thereof for forming the PCB (LP) exposed simultaneously on both sides;
**characterized in that**, in step E), the PCB is secured to said first assembly by means of a vacuum transmitted to the PCB placed thereon through bores provided along the edges of the first glass frame and the first photomask.

2. A process of aligning an unexposed PCB blank and two photomasks with each other without additional mechanical aids such as adjustable PCB positioning pins, and of subsequently exposing said blank for the production of two-sided PCBs, preferably for use as the inner layers of multi-layer PCBs, with optical positioning means provided along the edges of the photomasks and of the PCB, said process comprising the following steps:
a) Providing a first assembly comprising a first photomask (FM1) placed on a first glass frame (GR1) adjustable in its plane in the x, y and ϕ coordinates;
b) providing a second assembly comprising a photomask (FM2) placed on a second glass frame (GR2) located in a fixed xy position but adjustable in the z direction and parallel to said second assembly, and moving said second glass frame (GR2) in the z direction to a position spaced a small distance from said first assembly (GR1 + FM1);
c) aligning the first assembly (GR1+ FM1) in the x, y and ϕ coordinates with the second assembly (GR2 + FM2) in the aforesaid fixed xy position thereof by means of cameras (K1, K2, etc.) in cooperation with the optical positioning aids provided on the first photomask (FM1) and the second photomask (FM2);
d) separating the first assembly (GR1 + FM1) from the second assembly (GR2 + FM2) a distance sufficient for moving the PCB (LP) to be exposed into a fixed xy position in the area between the first assembly (GR1 + FM1) and the second assembly (GR2 + FM2);
e) lowering the PCB in the z coordinate onto the first assembly and fixing the PCB (LP) on the first assembly (GR1 + FM1) for forming a third assembly (GR1 + FM1 + LP) comprising the first glass frame, the first photomask and the PCB;
f) lowering the second assembly (GR2 + FM2) in the z coordinate onto the correspondingly aligned third assembly (GR1 + FM1 + LP) and fixing it by means of a cassette vacuum for forming a fourth assembly (GR1 + FM1 + LP + FM2 + GR2) comprising the first glass frame, the first photomask, the PCB, the second photomask and the second glass frame; and
g) exposing said fourth assembly (GR1 + FM1 + LP + FM2 + GR2) from both sides of the PCB (LP) for forming said PCB (LP) simultaneously exposed on both sides;
**characterized in that**, in step e), the PCB is secured on the first assembly by means of a vacuum which is transferred through bores positioned along the edges of the first glass frame and of the first photomask to the PCB placed on said first assembly.

3. Apparatus for performing the process of claim 1, comprising the following features:
A) A first assembly comprising a first photomask (FM1) placed on a first glass frame (GR1) adjustable in its plane in the x, y and ϕ coordinates;
B) a second assembly comprising a second photomask (FM2) placed on a second glass frame (GR2) in a fixed xy position but ajustable in the z direction and parallel to said first assembly, said second glass frame initially disposed at a distance from first assembly (GR1 + FM1) in the z direction;
C) an inlet section of the exposure apparatus for moving the PCB (LP) to be exposed into a fixed xy position in the area between the first assembly (GR1 + FM1) and the second assembly (GR2 + FM2);
D) cameras (K1, K2, etc.) for aligning the first assembly (GR1+ FM1) in the x, y and ϕ coordinates with the PCB (LP) introduced between the first and second assemblies in the aforesaid fixed position thereof in cooperation with said optical positioning aids on the photomask (FM1) and on the PCB (LP);
E) a z-stroke servo drive for lowering the PCB in the z coordinate and means for fixing the PCB (LP) on the correspondingly aligned first assembly (GR1 + FM1) for forming a third assembly (GR1 + FM1 + LP) comprising the first glass frame, the first photomask and the PCB;
F) cameras (K1, K2, etc.) for aligning said third assembly (GR1 + FM1 + LP) in the x, y and ϕ coordinates with said second assembly (GR2 + FM2) in cooperation with the optical positioning aids on the photomasks (FM1 and FM2, respectively) and on the PCB (LP);
G) jackscrews for lowering said second assembly (GR2 + FM2) in the z coordinate and placing it down on the correspondingly aligned third assembly (GR1 + FM1 + LP) and fixing it by means of a cassette vacuum for forming a fourth assembly (GR1 + FM1 + LP + FM2 + GR2) comprising said first glass frame, first photomask, PCB, second photomask and second glass frame; and
H) light sources for exposing said fourth assembly (GR1 + FM1 + LP + FM2 + GR2) from both sides thereof for forming the PCB (LP) simultaneously exposed on both sides;
**characterized in that**, in feature E), the means of fixing the PCB on said first assembly comprise vacuum bores which extend through the first glass frame and the first photomask to securely hold the PCB via the vacuum applied thereto.

4. Apparatus for performing the process of claim 2, comprising the following features:
a) A first assembly comprising a first photomask (FM1) placed on a first glass frame (GR1) adjustable in its plane in the x, y and ϕ coordinates;
b) a second assembly comprising a second photomask (FM2) placed on a second glass frame (GR2) in a fixed xy position but ajustable in the z direction and parallel to said first assembly, said second glass frame movable in the z direction to assume a position at a small distance from first assembly (GR1 + FM1);
c) cameras (K1, K2, etc.) for aligning the first assembly (GR1 + FM1) in the x, y and ϕ coordinates with the second assembly (GR2 + FM2) in the aforesaid fixed xy position thereof in cooperation with the optical positioning aids on the firs photomask (FM1) and on the second photomask (FM2);
d) jackscrews for separating the second assembly (GR2 + FM2) from the first assembly (GR1 + FM1) a distance sufficient for moving the PCB (LP) to be exposed to a fixed xy position in the area between the first assembly (GR1 + FM1) and the second assembly (GR2 + FM2);
e) a z-stroke servo drive for lowering the PCB in the z coordinate and means for fixing the PCB (LP) on the correspondingly aligned first assembly (GR1 + FM1) for forming a third assembly (GR1 + FM1 + LP) comprising the first glass frame, the first photomask and the PCB;
f) jackscrews for lowering said second assembly (GR2 + FM2) in the z coordinate and placing it down on the correspondingly aligned third assembly (GR1 + FM1 + LP) to be fixed by means of a cassette vacuum for forming a fourth assembly (GR1 + FM1 + LP + FM2 + GR2) comprising said first glass frame, first photomask, PCB, second photomask and second glass frame; and
g) light sources for exposing said fourth assembly (GR1 + FM1 + LP + FM2 + GR2) from both sides thereof for forming the PCB (LP) simultaneously exposed on both sides;
**characterized in that**, in feature e), the means of fixing the PCB on said first assembly comprise vacuum bores which extend through the first glass frame and the first photomask to securely hold the PCB via a vacuum applied thereto.

## Revendications

1. Procédé pour aligner une ébauche de plaquette à circuits imprimés non exposée et deux photomasques entre eux sans moyens auxiliaires mécaniques supplémentaires, comme par exemple des tiges de positionnement réglables pour les plaquettes à circuits imprimés, et pour l'exposition ultérieure pour la fabrication de plaquettes à circuits imprimés double face, de préférence pour l'utilisation en tant que couches extérieures de plaquettes à circuits imprimés multicouche, selon lequel des aides optiques de positionnement sont disposés sur le bord des photomasques et de la plaquette à circuits imprimés, comprenant les étapes suivantes consistant à:
A) prévoir un premier dispositif formé d'un premier photomasque (FM1) sur un cadre en verre (GR1) réglable dans un plan selon les coordonnées x, y et ϕ,
B) prévoir un second dispositif formé d'un second photomasque (FM2) sur un second cadre en verre (GR2), qui est disposé dans une position xy fixe, mais réglable dans la direction z et parallèle au premier dispositif et qui est séparé, dans la direction z, par une distance par rapport au premier dispositif (GR1+FM1);
C) introduire la plaquette à circuits imprimés à exposer (LP) dans une position xy fixe dans la zone située entre le premier dispositif (GR1+FM1) et le second dispositif (GR2+FM2);
D) aligner le premier dispositif (GR1+FM1) conformément aux coordonnées x,y et ϕ sur la plaquette à circuits imprimés (LP) dans la position fixe indiquée précédemment à l'aide d'appareils de prise de vues (K1, K2, etc.) en coopération avec les aides de positionnement optiques sur le photomasque (FM1) et sur la plaquette à circuits imprimés (LP);
E) abaisser la plaquette à circuits imprimés (LP) suivant la coordonnée z et la fixer sur le premier dispositif (GR1+FM1) aligné de façon correspondante, pour former un troisième dispositif constitué du premier cadre en verre et du premier photomasque et de la plaquette à circuits imprimés (GR1+FM1+LP);
F) aligner le troisième dispositif (GR1+FM1+LP) conformément aux coordonnées x, y et ϕ sur le second dispositif (GR2+FM2) à laide des appareils de prise de vues (K1, K2, etc.) en coopération avec les aides de positionnement optiques sur les photomasques (FM1 et FM2) et sur la plaquette à circuits imprimés (LP);
G) abaisser le second dispositif (GR2+FM2) suivant la coordonnée z et appliquer le dispositif sur le troisième dispositif (GR1+FM1+LP) aligné de façon correspondante et le fixer à l'aide d'une dépression de cassette pour réaliser un quatrième dispositif formé par le premier cadre en verre et le premier photomasque et la plaquette à circuits imprimés et le second photomasque et le second cadre en verre (GR1+FM1+LP+FM2+GR2);
H) exposer le quatrième dispositif (GR1+FM1+LP+FM2+GR2) sur ses deux faces pour former la plaquette à circuits imprimés (LP) exposée simultanément sur ses deux faces;
**caractérisé en ce que** lors de l'étape E) on fixe la plaquette à circuits imprimés sur le premier dispositif au moyen d'une dépression, qui est transmise au moyen de perçages formés dans le bord du premier cadre en verre et du premier photomasque, à la plaquette à circuits imprimés disposée sur ces derniers.

2. Procéder pour aligner une ébauche de plaquette à circuits imprimés non exposée et deux photomasques entre eux sans moyens auxiliaires mécaniques supplémentaires, comme par exemple des tiges de positionnement réglables pour la plaquette à circuits imprimés, et pour l'exposition ultérieure pour la fabrication de plaquettes à circuits imprimés double face, de préférence pour l'utilisation en tant que couches intérieures de plaquettes à circuits imprimés multicouche, selon lequel des aides optiques de positionnement sont disposés sur le bord des photomasques, comprenant les étapes suivantes consistant à:
a) prévoir un premier dispositif formé d'un premier photomasque (FM1) sur un cadre en verre (GR1) réglable dans un plan selon les coordonnées x, y et ϕ,
b) prévoir un second dispositif formé d'un second photomasque (FM2) sur un second cadre en verre (GR2), qui est disposé dans une position xy fixe, mais est réglable dans la direction z et est parallèle au premier dispositif et est introduit, dans la direction z, à une faible distance du premier dispositif (GR1+FM1);
c) aligner le premier dispositif (GR1+FM1) conformément aux coordonnées x,y et ϕ sur le second dispositif (GR2+FM2) dans la position yx fixe indiquée précédemment, à l'aide d'appareils de prise de vues (K1, K2, etc.) en coopération avec les aides de positionnement optiques sur le premier photomasque (FM1) et sur le second photomasque (FM2);
d) écarter l'un de l'autre le premier dispositif (GR1+FM1) et le second dispositif (GR2+FM2) pour les amener à une distance suffisante pour l'introduction de la plaquette à circuits imprimés exposée (LP) dans une position xy fixe dans la zone située entre le premier dispositif (GR1+FM1) et le second dispositif (GR2+FM2);
e) abaisser la plaquette à circuits imprimés suivant la coordonnée z sur le premier dispositif (GR1+FM1) et fixer la plaquette à circuits imprimés (LP) sur le premier dispositif (GR1+FM1) pour la formation d'un troisième dispositif constitué par le premier cadre en verre et le premier photomasque et la plaquette à circuits imprimés (GR1+FM1+LP);
f) abaisser suivant la coordonnée z le second dispositif (GR2+FM2) sur le troisième dispositif (GR1+FM1+LP) aligné de façon correspondante et fixer ce dispositif à l'aide d'une dépression de cassette pour la formation d'un quatrième dispositif constitué par le premier cadre en verre et le premier photomasque et la plaquette à circuits imprimés et un second photomasque et le second cadre en verre (GR1+FM1+LP+FM2+GR2);
g) exposer le quatrième dispositif (GR1+FM1+LP+FM2+GR2) à partir de ses deux faces pour former la plaquette à circuits imprimés (LP) exposée simultanément sur ses deux faces;
**caractérisé en ce que** lors de l'étape e) on fixe la plaquette à circuits imprimés sur le premier dispositif au moyen d'une dépression, qui est transmise au moyen de perçages formés dans le bord du premier cadre en verre et du premier photomasque, à la plaquette à circuits imprimés disposée au-dessus de ces derniers.

3. Dispositif pour la mise en oeuvre du procédé selon la revendication 1, présentant les caractéristiques suivantes:
A) un premier dispositif formé d'un premier photomasque (FM1) sur un cadre en verre (GR1) réglable dans un plan selon les coordonnées x, y et ϕ,
B) un second dispositif formé d'un second photomasque (FM2) sur un second cadre en verre (GR2), qui est disposé dans une position xy fixe, mais est réglable dans la direction z, est parallèle au premier dispositif et est séparé, dans la direction z, par une distance par rapport au premier dispositif (GR1+FM1);
C) une section d'entrée de l'appareil d'exposition pour introduire la plaquette à circuits imprimés à exposer (LP) dans une position xy fixe dans la zone située entre le premier dispositif (GR1+FM1) et le second dispositif (GR2+FM2);
D) des appareils de prise de vues (K1, K2, etc.) pour aligner le premier dispositif (GR1+FM1) conformément aux coordonnées x,y et ϕ sur la plaquette à circuits imprimés (LP) dans la position fixe indiquée précédemment en coopération avec les aides de positionnement optiques sur le photomasque (FM1) et sur la plaquette à circuits imprimés (LP);
E) un dispositif d'entraînement d'asservissement pour la course suivant z pour abaisser la plaquette à circuits imprimés (LP) suivant la coordonnée z et des moyens pour fixer la plaquette à circuits imprimés (LP) sur le premier dispositif (GR1+FM1) aligné de façon correspondante, pour former un troisième dispositif constitué du premier cadre en verre et du premier photomasque et de la plaquette à circuits imprimés (GR1+FM1+LP);
F) des appareils de prise de vues (K1, K2, etc.) pour aligner le troisième dispositif (GR1+FM1+LP) conformément aux coordonnées x,y et ϕ sur le second dispositif (GR2+FM2) en coopération avec les aides de positionnement optiques sur les photomasques (FM1 et FM2) et sur la plaquette à circuits imprimés (LP);
G) des broches de levage pour abaisser le second dispositif (GR2+FM2) suivant la coordonnée z et appliquer le dispositif sur le troisième dispositif (GR1+FM1+LP) aligné de façon correspondante et le fixer à l'aide d'une dépression à cassette pour réaliser un quatrième dispositif formé par le premier cadre en verre et le premier photomasque et la plaquette à circuits imprimés et le second photomasque et le second cadre en verre (GR1+FM1+LP+FM2+GR2);
H) une source de lumière pour exposer le quatrième dispositif (GR1+FM1+LP+FM2+GR2) sur ses deux faces pour former la plaquette à circuits imprimés (LP) exposée simultanément sur ses deux faces;
**caractérisé en ce que** dans la caractéristique E), des moyens pour fixer la plaquette à circuits imprimés sur le premier dispositif sont des perçages à dépression, qui s'étendent à travers le premier cadre en verre et le premier photomasque et fixent la plaquette à circuits imprimés sur la base de la dépression appliquée.

4. Dispositif pour la mise en oeuvre du procédé selon la revendication 2, présentant les caractéristiques suivantes:
a) un premier dispositif formé d'un premier photomasque (FM1) sur un cadre en verre (GR1) réglable dans un plan selon les coordonnées x, y et ϕ,
b) un second dispositif formé d'un second photomasque (FM2) sur un second cadre en verre (GR2), qui est disposé dans une position xy fixe, mais est réglable dans la direction z et est parallèle au premier dispositif et est introduit, dans la direction z, à une faible distance par rapport au premier dispositif (GR1+FM1);
c) des appareils de prise de vues (K1, K2, etc.) pour aligner le premier dispositif (GR1+FM1) conformément aux coordonnées x,y et ϕ sur le second dispositif (GR2+FM2) dans la position xy fixe indiquée précédemment, en coopération avec les aides de positionnement optiques sur le premier photomasque (FM1) et sur le second photomasque (FM2);
d) des broches de levage pour écarter l'un de l'autre le premier dispositif (GR1+FM1) et le second dispositif (GR2+FM2) pour les amener à une distance suffisante pour l'introduction de la plaquette à circuits imprimés exposée (LP) dans une position xy fixe dans la zone située entre le premier dispositif (GR1+FM1) et le second dispositif (GR2+FM2);
e) un dispositif d'entraînement d'asservissement pour la course suivant z pour abaisser la plaquette à circuits imprimés suivant la coordonnée z et des moyens pour fixer la plaquette à circuits imprimés (LP) sur le premier dispositif (GR1+FM1) pour la formation d'un troisième dispositif constitué par un premier cadre en verre et un premier photomasque et la plaquette à circuits imprimés (GR1+FM1+LP);
f) des broches de levage pour abaisser suivant la coordonnée z le second dispositif (GR2+FM2) sur le troisième dispositif (GR1+FM1+LP) orienté de façon correspondante et fixer ce dispositif à l'aide d'une dépression à cassette pour la formation d'un quatrième dispositif constitué par un premier cadre en verre et un premier photomasque et la plaquette à circuits imprimés et un second photomasque et un second cadre en verre (GR1+FM1+LP+FM2+GR2);
g) des sources de lumière pour exposer le quatrième dispositif (GR1+FM1+LP+FM2+GR2) à partir de ses deux faces pour former la plaquette à circuits imprimés (LP) exposée simultanément sur ses deux faces;
**caractérisé en ce que** dans la caractéristique e) les moyens pour fixer la plaquette à circuits imprimés sur le premier dispositif sont des perçages à dépression, qui s'étendent à travers le premier cadre en verre et le premier photomasque et fixent la plaquette à circuits imprimés sur la base de la dépression appliquée.
